# FASCICULE DE BREVET EUROPEEN

(11) **EP 0 553 020 B1**
(45) Date de publication et mention de la délivrance du brevet: **18.09.1996**
(21) Numéro de dépôt: 93400117.3
(22) Date de dépôt: 19.01.1993
(51) Int. Cl.: H03K 19/0175, H03K 19/00, H03K 19/003, H03K 19/01

(54) **Etage de sortie TTL-CMOS pour circuit intégré**
TTL-CMOS-Ausgangsstufe für integrierte Schaltungen
TTL-CMOS output stage for integrated circuits

(30) Priorité: 20.01.1992 FR 9200542
(43) Date de publication de la demande: 28.07.1993
(73) Titulaire: MATRA MHS, F-44087 Nantes Cédex 03 (FR)
(72) Inventeur: Hirschauer, Pierre, F-78360 Montesson (FR)
(74) Mandataire: Fréchède, Michel

(56) Documents cités:
- EP-A- 0 307 323
- US-A- 4 717 847
- PATENT ABSTRACTS OF JAPAN vol. 11, no. 130 (E-502)(2577) 23 Avril 1987
- PATENT ABSTRACTS OF JAPAN vol. 12, no. 99 (E-594)(2946) 31 Mars 1988
- PATENT ABSTRACTS OF JAPAN vol. 7, no. 208 (E-198)(1353) 14 Septembre 1983
- PATENT ABSTRACTS OF JAPAN vol. 10, no. 79 (E-391)(2136) 28 Mars 1986

## Description

L'invention est relative à un étage de sortie TTL-CMOS, ou étage tampon, pour circuits intégrés.

Dans les circuits intégrés actuels, le problème de l'interconnexion du coeur du circuit intégré, assurant la fonction pour laquelle celui-ci a été conçu, avec les circuits électroniques environnants reste un problème technique majeur, en raison notamment de la variété des standards de signaux en amplitude de tension ou d'intensité susceptibles d'être requis pour assurer la transmission de ces signaux dans des conditions satisfaisantes sur ces derniers.

Parmi les standards de signaux actuels, les signaux aux normes TTL (Transistor Transistor Logic) ou CMOS sont les plus utilisés. On rappelle que dans le cas des signaux aux normes TTL, l'amplitude de tension des signaux est comprise entre 5 V et 2,4 V pour le niveau logique haut et 0 V et 0,4 V pour le niveau logique bas, une intensité de 32mA pouvant être délivrée, alors que dans le cas des signaux aux normes CMOS, l'amplitude de tension de ces signaux est sensiblement égale à 5 V pour le niveau logique haut et à 0 V pour le niveau logique bas.

La présente invention a pour objet la mise en oeuvre d'un étage de sortie TTL-CMOS pour circuit intégré permettant de réaliser une adaptation des signaux logiques, délivrés par le coeur d'un circuit intégré, aux normes des signaux standards TTL ou CMOS.

Un autre objet de la présente invention est la mise en oeuvre d'un étage de sortie TTL-CMOS pour circuit intégré, présentant une capacité électrique d'entrée de l'ordre de 1 pF.

Un autre objet de la présente invention est la mise en oeuvre d'un étage de sortie TTL-CMOS à faible bruit.

L'étage de sortie TTL-CMOS pour circuit intégré objet de la présente invention est remarquable en ce qu'il comprend, un transistor bipolaire et un transistor MOS connectés en série entre la tension d'alimentation et la tension de référence, le point commun du transistor bipolaire et du transistor MOS formant la borne de sortie de l'étage de sortie TTL-CMOS. Une première voie de commande d'entrée est prévue et comprend un premier inverseur dont l'entrée constitue la borne d'entrée de l'étage TTL-CMOS et dont la sortie est reliée à la grille du transistor MOS par l'intermédiaire d'une première résistance.

Une deuxième voie de commande d'entrée est prévue comprenant un deuxième inverseur dont l'entrée inverseur est reliée à la sortie du premier inverseur et dont la sortie est reliée à la base du transistor bipolaire par l'intermédiaire d'une deuxième résistance. Les résistances ont une valeur déterminée de façon à limiter, d'une part, le courant transitoire à la commutation et, d'autre part, le courant moyen fourni par le transistor bipolaire.

L'étage de sortie TTL-CMOS objet de l'invention trouve application à la réalisation de circuits intégrés, plus particulièrement de circuits tampons ou d'adaptation de signaux logiques disposés entre le coeur du circuit intégré proprement dit et le boîtier de celui-ci.

Un étage de sortie TTL-CMOS selon le préambule de la revendication 1 est connu du document US-A-4717847.

Une description plus détaillée de l'étage de sortie TTL-CMOS pour circuit intégré selon l'invention sera donnée ci-après dans la description et les dessins dans lequels :
- la figure 1a représente un schéma fonctionnel de l'étage de sortie TTL-CMOS objet de la présente invention,
- la figure 1b représente un chronogramme des signaux obtenus en différents points remarquables de la figure 1a,
- la figure 2a représente un étage de sortie conforme à l'objet de la présente invention dans une variante de réalisation plus particulièrement destinée à adapter les signaux logiques d'entrée au niveau TTL,
- la figure 2b représente des chronogrammes de signaux obtenus en des points remarquables de la figure 2a,
- la figure 3a représente un étage de sortie conforme à l'objet de la présente invention dans une première variante de réalisation plus particulièrement destinée à adapter des signaux logiques d'entrée au niveau CMOS,
- la figure 3b représente un étage de sortie conforme à l'objet de la présente invention dans une deuxième variante de réalisation plus particulièrement destinée à adapter des signaux logiques d'entrée au niveau CMOS,
- la figure 3c représente un chronogramme de signaux obtenus en des points remarquables identiques des premier et deuxième modes de réalisation représentés en figure 3a et 3b,
- la figure 4 représente, à titre d'exemple non limitatif, un mode de réalisation et d'implantation des composants permettant la mise en oeuvre du mode de réalisation de la figure 3b.

L'étage de sortie TTL-CMOS pour circuit intégré objet de la présente invention sera tout d'abord décrit en liaison avec la figure 1a.

Ainsi qu'on l'observera sur la figure précitée, l'étage de sortie TTL-CMOS objet de la présente invention comprend, d'une manière générale, un transistor bipolaire 1 et un transistor MOS 2 connectés en série entre la tension d'alimentation, notée VDD, et la tension de référence, la masse, notée VSS. Par connexion série des transistors bipolaire 1 et MOS 2, on comprend que l'émetteur du transistor bipolaire 1 est connecté au drain du transistor MOS 2. Le point commun du transistor bipolaire et du transistor MOS forme la borne de sortie BS de l'étage de sortie TTL-CMOS.

De manière générale, la tension d'alimentation VDD est prise égale à 5 volts.

En outre, ainsi qu'on l'observera sur la figure 1a précitée, l'étage de sortie TTL-CMOS objet de la présente invention comprend une première voie d'entrée de commande de commutation comprenant un premier inverseur 3 dont l'entrée constitue la borne d'entrée BE de l'étage TTL-CMOS et dont la sortie est reliée à la grille du transistor MOS 2 par l'intermédiaire d'une première résistance 4.

En outre, une deuxième voie d'entrée de commande de commutation est prévue et comprend un deuxième inverseur 5 dont l'entrée est reliée à la sortie du premier inverseur 3 et dont la sortie est reliée à la base du transistor bipolaire 1, par l'intermédiaire d'une deuxième résistance 6. Les résistances 4 et 6 ont une valeur déterminée de façon à limiter d'une part le courant transitoire à la commutation et d'autre part le courant moyen fourni par le transistor bipolaire 1.

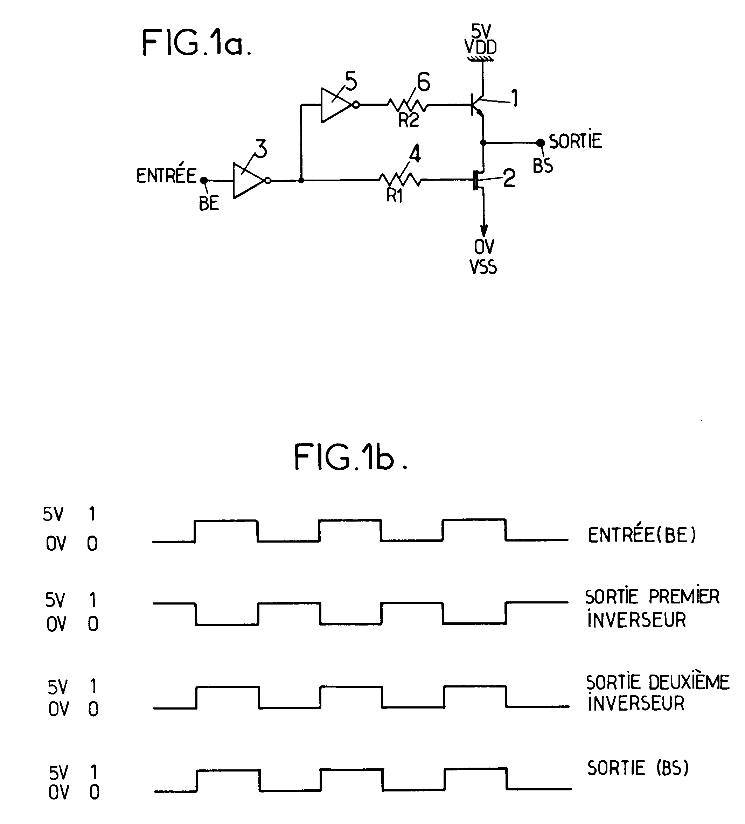

Un chronogramme des signaux engendrés au point remarquable de l'étage de sortie TTL-CMOS objet de l'invention représenté en figure 1a est représenté en figure 1b. Les signaux d'entrée sont des signaux logiques délivrés par le coeur d'un circuit intégré. Ces signaux logiques ont de manière habituelle un niveau logique haut, noté 1, et un niveau logique bas, noté 0, ces niveaux logiques correspondant à des valeurs de tension de 5 V, respectivement 0 V, pour une intensité très faible, de l'ordre de quelques micro-ampères. Les inverseurs 3 et 5 peuvent être réalisés respectivement par un inverseur BICMOS et par un inverseur CMOS, ce qui permet de minimiser la capacité d'entrée de l'étage de sortie TTL-CMOS à une valeur de l'ordre de 1 pF.

On notera que les opérateurs CMOS ou TTL utilisés, en aval de l'étage de sortie objet de la présente invention, n'ont qu'une consommation dynamique. Il en résulte des appels de courant importants sur l'alimentation. Le choix adapté de la valeur des résistances 6 et 4, placé dans les circuits de base, respectivement de grille, du transistor bipolaire 1 et du transistor MOS 2, permettent ainsi de réaliser, par limitation de la pente du signal de sortie, des étages de sortie TTL-CMOS à faible bruit. En effet, la résistance 6 limite le courant de base du transistor bipolaire 1 et la résistance 4 introduit un facteur à constante de temps capacitive sur la grille du transistor MOS 2. Pour des versions rapides d'étage de sortie TTL-CMOS, conformes à l'objet de la présente invention, les valeurs des résistances 4 et 6 précitées peuvent être rendues très faibles, ou nulles.

Sur la borne de sortie BS, le signal obtenu correspondant est representé en figure 1b, ce signal bien entendu correspondant sensiblement aux signaux d'entrée, mais le courant susceptible d'être délivré par la borne de sortie BS pouvant atteindre des valeurs de l'ordre de 30 milli-ampères. Ce courant est bien entendu délivré par le transistor bipolaire 1.

Compte tenu du standard des signaux TTL, on comprend bien sûr que les signaux délivrés en sortie de l'étage de sortie objet de la présente invention satisfont à ce standard.

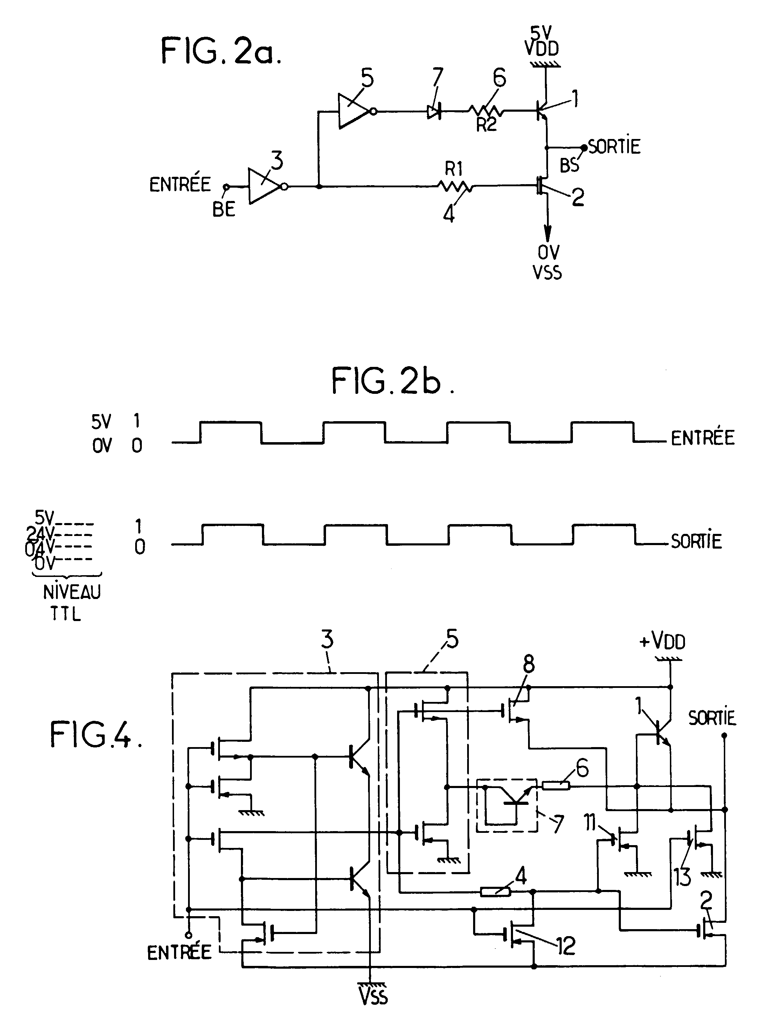

Toutefois, en vue d'augmenter la rapidité de commutation au niveau TTL, c'est-à-dire tout en restant compatible avec le standard de ces signaux, la deuxième voie d'entrée de commande de commutation comprend, ainsi que représenté en figure 2a, en aval du deuxième inverseur 5, une diode 7. Cette diode permet de ramener la valeur du niveau logique haut en sortie de l'étage de sortie objet de l'invention, à la valeur VDD - 2 Vbe. On rappelle que Vbe représente la valeur de la tension base-émetteur du transistor bipolaire 1 à l'état conducteur.

Sur la figure 2b, on a représenté d'une part les signaux logiques présents sur la borne d'entrée BE, et d'autre part, les signaux présents sur la borne de sortie BS. On notera que compte tenu de la présence de la diode 7, l'amplitude des signaux de sortie est comprise entre 0 et 3,2 V environ, ce qui permet, d'une part, de satisfaire au standard des signaux TTL, et d'autre part, de réduire le temps de transition entre le niveau logique bas et le niveau logique haut.

On notera que la diode 7 peut être formée soit par une diode silicium, ou, par un autre transistor bipolaire, de dimension inférieure au transistor bipolaire 1, car le courant de base est plus faible que celui d'émetteur, et dont la base et le collecteur sont reliés en court-circuit.

Dans le mode de réalisation de la figure 2a, la compatiblité avec le standard des niveaux TTL permet de délivrer un courant de 32 milli-ampères pour le niveau logique bas inférieur à 0,4 V. Dans ce but, un transistor MOS de type N par exemple, le transistor 2, a été implanté pour assurer le niveau logique bas précité, ce transistor MOS étant un transistor large, alors que pour assurer le niveau logique haut, la diode 7 et le transistor bipolaire 1, transistor NPN par exemple, permettent d'obtenir la limitation de l'excursion de tension pour la rapidité de commutation accrue recherchée.

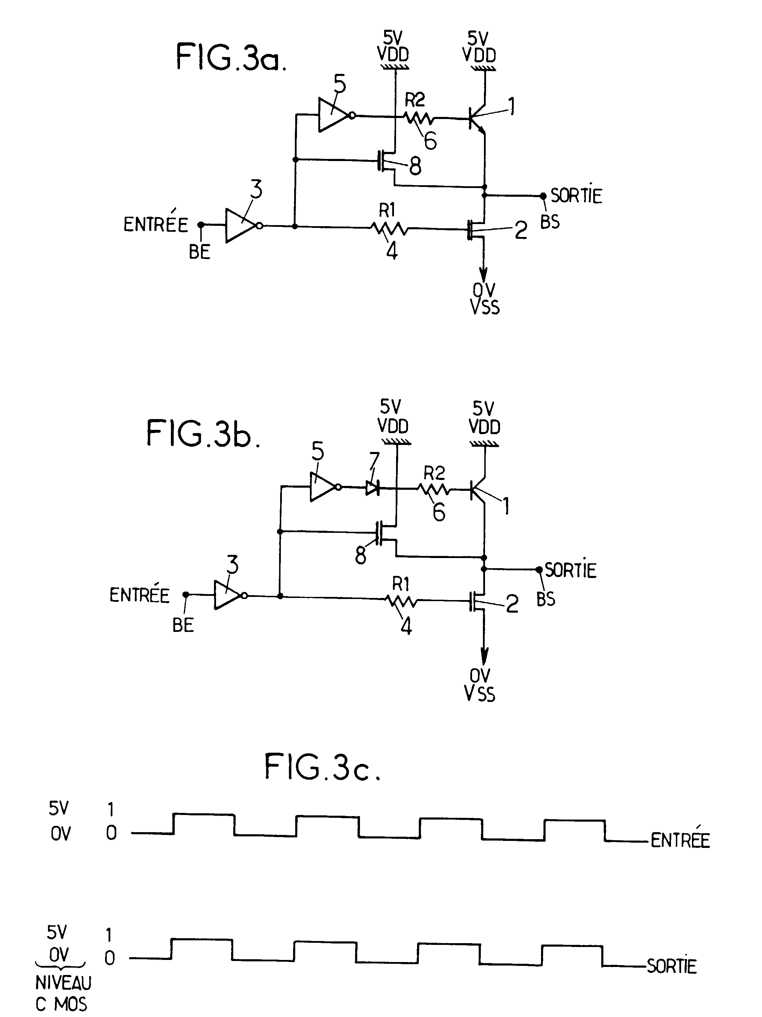

Une variante de réalisation de l'étage de sortie TTL-CMOS objet de la présente invention sera donnée en liaison avec les figures 3a et 3b dans le cas où il est nécessaire d'assurer la compatibilité de commutation au niveau CMOS précédemment mentionné dans la description.

Dans une première variante de réalisation correspondante, l'étage de sortie, tel que représenté en figure 3a, comporte en outre un transistor MOS auxiliaire 8 dont l'électrode de drain est reliée à la tension d'alimentation VDD, et l'électrode de source au point commun du transistor bipolaire 1 et du transistor MOS 2. L'électrode de grille du transistor auxiliaire 8 est alors reliée en sortie du premier inverseur 3. Le transistor auxiliaire 8 permet lors de la mise en conduction de celui-ci d'imposer au point de sortie de l'étage de sortie objet de la présente invention la valeur de la tension d'alimentation VDD.

On notera que dans le mode de réalisation de la figure 3a, celui-ci correspond sensiblement au mode de réalisation de l'étage de sortie objet de la présente invention de la figure 1a, auquel a été rajouté le transistor auxiliaire 8.

Toutefois, le mode de réalisation de la figure 3a n'est pas limitatif et, bien entendu, le transistor auxiliaire 8 peut également être rajouté au mode de réalisation de la figure 2a pour assurer la compatibilité de commutation au niveau CMOS.

Dans ce cas, ainsi que représenté en figure 3b, le transistor MOS auxiliaire 8 est connecté de la même manière que dans le cas de la figure 3a. Toutefois, dans le cas de la figure 3b, en raison de la présence de la diode 7, le transistor auxiliaire MOS 8 doit assurer un rattrapage de tension plus important puisque, dans ce cas là, la borne de sortie BS, normalement amenée au potentiel VDD - 2 Vbe en raison de la présence de la diode 7, est ramenée en fait à la valeur de la tension d'alimentation VDD par le transistor MOS 8 en conduction, d'où le rattrapage plus important de tension effectué par ce dernier.

Sur la figure 3c, on a représenté un chronogramme des signaux présents en entrée, signaux logiques sur la borne d'entrée BE, respectivement les signaux de sortie au niveau CMOS entre les valeurs de tension 0 V et 5 V.

Dans les modes de réalisation décrits en relation avec les figures 1a, 2a et 3a, de manière non limitative, le transistor bipolaire 1 est un transistor de type NPN, le transistor MOS 2 étant un transistor de type NMOS. Le transistor MOS auxiliaire 8 est alors un transistor complémentaire de type PMOS.

Une description plus détaillée au niveau des composants utilisés pour la réalisation de l'étage de sortie TTL-CMOS objet de la présente invention, sera donnée en liaison avec la figure 4.

D'une manière générale, on considèrera que les inverseurs 3 et 5 peuvent être réalisés par des inverseurs de type BICMOS respectivement CMOS. Pour une description plus détaillée des qualités respectives de ce type d'inverseur, on pourra se reporter à l'article intitulé "La technologie BICMOS" publié dans la revue TLE n° 544 en Mai 1989 par Pierre Hirschauer.

En outre, ainsi que représenté sur la figure 4, sur laquelle les éléments fonctionnels des figures 1a, 2a et 3a précédentes ont été représentés, l'étage de sortie TTL-CMOS objet de la présente invention peut avantageusement comporter des transistors de commutation auxiliaires notés 11, 12, 13, permettant d'anticiper la commande de commutation du transistor bipolaire 1 et du transistor MOS 2. On notera que les transistors de commutation auxiliaires sont avantageusement constitués par des transistors de type MOS, et que ces transistors, placés respectivement en commutation entre la base du transistor bipolaire 1, transistors auxiliaires 11 et 13, et entre la grille du transistor MOS 2 et la tension de référence VSS permettent essentiellement d'anticiper la commutation des transistors bipolaire 1 et transistor MOS 2 du temps de commutation des inverseurs, les transistors auxiliaires 12 et 13 étant commandés par le signal logique d'entrée, soit antérieurement à la commutation de l'inverseur 3, et le transistor 11 étant commandé par la tension d'entrée de l'inverseur 5, ou par la tension appliquée sur la grille du transistor MOS 2. On notera enfin qu'en ce qui concerne le transistor MOS auxiliaire 8 permettant d'assurer la commutation au niveau CMOS, celui-ci peut être réalisé par un ou deux transistors en cascade sans inconvénient.

On notera enfin que les inverseurs 3 et 5 peuvent également être constitués par des inverseurs trois états de type classique.

On a ainsi décrit un étage de sortie TTL-CMOS particulièrement avantageux dans la mesure où par la mise en oeuvre d'une modification mineure, présence ou absence du transistor auxiliaire de commutation, la compatibilité des signaux de sortie engendrés, soit au niveau TTL, soit au niveau CMOS, peut être assurée.

## Revendications

1. Etage de sortie TTL-CMOS pour circuit intégré, avec:
- un transistor bipolaire (1) et un transistor MOS (2) connectés en série entre une tension d'alimentation (VDD) et une tension de référence (VSS), le point commun dudit transistor bipolaire et du transistor MOS formant la borne de sortie (BS) dudit étage de sortie TTL-CMOS, caractérisé en ce qu'il comprend aussi:
- une première voie d'entrée de commande de commutation comprenant un premier inverseur (3), dont l'entrée constitue la borne d'entrée (BE) dudit étage TTL-CMOS, et dont la sortie est reliée à la grille dudit transistor MOS (2) par l'intermédiaire d'une première résistance (4),
- une deuxième voie d'entrée de commande de commutation comprenant un deuxième inverseur (5) dont l'entrée est reliée à la sortie dudit premier inverseur (3) et dont la sortie est reliée à la base dudit transistor bipolaire (1) par l'intermédiaire d'une deuxième résistance (6), lesdites résistance ayant une valeur déterminée de façon à limiter, d'une part, le courant transitoire à la commutation et d'autre part le courant moyen fourni par ledit transistor bipolaire (1).

2. Etage de sortie selon la revendication 1, caractérisé en ce que lesdits premier (3) et deuxième (5) inverseur sont formés chacun par un inverseur BICMOS, respectivement un inverseur CMOS.

3. Etage de sortie selon la revendication 1 ou 2 précédente, caractérisé en ce que, en vue d'augmenter la rapidité de commutation au niveau TTL, ladite deuxième voie d'entrée de commande de commutation comprend, en aval dudit deuxième inverseur (5), une diode (7), ce qui permet de ramener la valeur du niveau logique haut en sortie dudit étage de sortie à la valeur VDD-2Vbe, où Vbe représente la valeur de la tension base-émetteur dudit transistor bipolaire (1) à l'étage conducteur.

4. Etage de sortie selon la revendication 3, caractérisé en ce que ladite diode (7) est formée par un autre transistor bipolaire, identique audit transistor bipolaire (1), dont la base et le collecteur sont reliés en court-circuit.

5. Etage de sortie selon l'une des revendications 1 à 4, caractérisé en ce que, en vue d'assurer la compatibilité de commutation au niveau CMOS, celui-ci comporte en outre un transistor MOS auxiliaire (8) dont l'électrode de drain est reliée à la tension d'alimentation VDD, l'électrode de source est reliée audit point commun du transistor bipolaire (1) et du transistor MOS (2) et dont l'électrode de grille est reliée en sortie dudit premier inverseur (3), ce qui permet, lors de la mise en conduction dudit transistor auxiliaire (8), d'imposer au point de sortie dudit étage de sortie la valeur de la tension d'alimentation.

6. Etage de sortie selon l'une des revendications 1 à 4, caractérisé en ce que ledit transistor bipolaire (1) est un transistor NPN, ledit transistor MOS (2) étant un transistor NMOS.

7. Etage de sortie selon les revendications 5 et 6, caractérisé en ce que ledit transistor MOS auxiliaire (8) est un transistor PMOS.

8. Etage de sortie selon les revendications 5, 6 et 7, caractérisé en ce qu'il comporte en outre des transistors de commutation auxiliaires (11, 12, 13) permettant d'anticiper la commande de commutation du transistor bipolaire (1) et du transistor MOS (2).

## Patentansprüche

1. TTL-CMOS-Ausgangsstufe für integrierte Schaltungen mit:
- einem bipolaren Transistor (1) und einem MOS-Transistor (2), die in Serie zwischen einer Speisungsspannung (VDD) und einer Referenzspannung (VSS) verbunden sind, wobei der gemeinsame Punkt dieses bipolaren Transistors und des MOS-Transistors den Ausgangskontakt (BS) dieser TTL-CMOS-Ausgangsstufe bilden,
dadurch gekennzeichnet,
daß sie außerdem aufweist:
- eine erste Eingangsbahn zur Steuerung der Umschaltung mit einem ersten Umkehrer (3), dessen Eingang den Eingangskontakt (BE) der TTL-CMOS-Stufe bildet und dessen Ausgang mit dem Gitter des Transistors MOS (2) durch Zwischenschaltung eines ersten Widerstandes (4) verbunden ist,
- eine zweite Eingangsbahn zur Steuerung der Umschaltung mit einem zweiten Umkehrer (5), dessen Eingang mit dem Ausgang des ersten Umkehrers (3) verbunden ist und dessen Ausgang mit der Basis des bipolaren Transistors (1) durch Zwischenschaltung eines zweiten Widerstands (6) verbunden ist, wobei die Widerstände einen derart vorbestimmten Wert haben, um einerseits den bei der Umschaltung fließenden Strom und andererseits den durch den bipolaren Transistor (1) gelieferten Strom zu begrenzen.

2. Ausgangsstufe nach Anspruch 1,
dadurch gekennzeichnet,
daß der erste (3) und der zweite (5) Umkehrer jeweils von einem Umkehrer BICMOS bzw. einem Umkehrer CMOS gebildet sind.

3. Ausgangsstufe nach Anspruch 1 oder 2,
dadurch gekennzeichnet,
daß zur Erhöhung der Schnelligkeit der Umschaltung im Niveau TTL die zweite Eingangsbahn zur Steuerung der Umschaltung stromabwärts des zweiten Umkehrers (5) eine Diode (7) aufweist, die es erlaubt, den Wert des hohen logischen Niveaus am Ausgang der Ausgangsstufe auf den Wert VDD-2Vbe zurückzuführen, wobei Vbe den Wert der Spannung Basis-Emitter des bipolaren Transistors (1) des Stufenleiters darstellt.

4. Ausgangsstufe nach Anspruch 3,
dadurch gekennzeichnet,
daß die Diode (7) von einem anderen bipolaren Transistor gebildet ist, der identisch zum bipolaren Transistor 1 ist, dessen Basis und Kollektor im Kurzschluß verbunden sind.

5. Ausgangsstufe nach irgendeinem der Ansprüche 1 bis 4,
dadurch gekennzeichnet,
daß zur Sicherstellung der Kompatibilität der Umschaltung im Niveau CMOS diese außerdem einen Hilfstransistor MOS (8) aufweist, dessen Bodenelektrode mit der Speisespannung VDD verbunden ist, wobei die Elektrode der Quelle mit dem gemeinsamen Punkt des bipolaren Transistors (1) und des Transistors MOS (2) verbunden ist, und dessen Gitterelektrode mit dem Ausgang des ersten Umkehrers (3) verbunden ist, was es erlaubt, während der Inleitungsetzung des Hilfstransistors (8) dem Ausgangspunkt der Ausgangsstufe den Wert der Speisespannung aufzuerlegen.

6. Ausgangsstufe nach irgendeinem der Ansprüche 1 bis 4,
dadurch gekennzeichnet,
daß der bipolare Transistor (1) ein Transistor NPN ist, wobei der Transistor MOS (2) ein Transistor NMOS ist.

7. Ausgangsstufe nach den Ansprüchen 5 und 6,
dadurch gekennzeichnet,
daß der Hilfstransistor MOS (8) ein Transistor PMOS ist.

8. Ausgangsstufe nach Anspruch 5, 6 und 7,
dadurch gekennzeichnet,
daß diese außerdem Hilfstransistoren zur Umschaltung (11,12,13) aufweist, die es erlauben, die Umschaltungssteuerung des bipolaren Transistors (1) und des Transistors MOS (2) vorauszusehen.

## Claims

1. TTL-CMOS output stage for an integrated circuit, with
- a bipolar transitor (1) and an MOS transistor (2) connected in series between a power supply voltage (VDD) and a reference voltage (VSS), the common point of said bipolar transistor and of the MOS transistor forming the output terminal (BS) of said TTL-CMOS output stage, characterized by said TTL-CMOS output stage further comprising :
- a first switching control input channel comprising a first inverter (3), whose input constitutes the input terminal (BE) of said TTL-CMOS stage and whose output is linked to the gate of said MOS transistor (2) by means of a first resistor (4),
- a second switching control input channel comprising a second inverter (5), whose input is linked to the output of said first inverter (3) and whose output is linked to the base of said bipolar transistor (1) by means of a second resistor (6), the said resistors having a value determined so as to limit, on the one hand, the transient current on switching and, on the other hand, the mean current supplied by said bipolar transistor (1).

2. Output stage according to claim 1, characterized by said first (3) and second (5) inverters being each formed by a BICMOS inverter, and a CMOS inverter respectively.

3. Output stage according to one of the preceding claims 1 or 2, characterized by, with a view to increasing the switching speed at the TTL level, said second switching control input channel comprising, downstream of said second inverter (5), a diode (7), which makes it possible to bring the value of the high logic level at the output of said output stage back to the value VDD-2Vbe, where Vbe represents the value of the base-emitter voltage of said bipolar transistor (1) in the conducting state.

4. Output stage according to claim 3, characterized by said diode (7) being formed by another bipolar transistor, identical to said bipolar transistor (1), whose base and collector are linked in short-circuit.

5. Output stage according to one of claims 1 to 4, characterized by, with a view to ensuring the switching compatibility at the CMOS level, said stage further comprising an auxiliary MOS transistor (8) whose drain electrode is linked to the power supply voltage VDD, whose source electrode is linked to said common point of the bipolar transistor (1) and of the MOS transistor (2) and whose gate electrode is linked to the output of said first inverter (3), which makes it possible, when said auxiliary transistor enters into conduction, to impose the value of the power supply voltage on the output point of said output stage.

6. Output stage according to one of claims 1 to 4, characterized by said bipolar transistor (1) being an NPN transistor, said MOS transistor (2) being an NMOS transistor.

7. Output stage according to claims 5 and 6, characterized by said auxiliary MOS transistor (8) being a PMOS transistor.

8. Output stage according to claims 5, 6 and 7, characterized by said output stage further comprising auxiliary switching transistors (11, 12, 13) making it possible to anticipate the switching command of the bipolar transistor (1) and of the MOS transistor (2).
